# EUROPÄISCHE PATENTSCHRIFT

(11) **EP 0 472 241 B1**
(45) Veröffentlichungstag und Bekanntmachung des Hinweises auf die Patenterteilung: **06.05.1998**
(21) Anmeldenummer: 91202088.0
(22) Anmeldetag: 15.08.1991
(51) Int. Cl.: G11C 16/04

(54) **Elektrisch programmier- und löschbarer Halbleiterspeicher und Verfahren zu seinem Betrieb**
Electrically programmable and erasable semiconductor memory and its operation method
Mémoire à semi-conducteurs électriquement programmable et effaçable et sa méthode d'opération

(30) Priorität: 21.08.1990 DE 4026408
(43) Veröffentlichungstag der Anmeldung: 26.02.1992
(73) Patentinhaber: Philips Patentverwaltung GmbH, 22335 Hamburg (DE); Philips Electronics N.V., 5621 BA Eindhoven (NL)
(72) Erfinder: Frerichs, Heinz-Peter, Dr.rer.nat., W-20259 Hamburg (DE)
(74) Vertreter: Poddig, Dieter, Dipl.-Ing.

(56) Entgegenhaltungen:
- EP-A- 0 317 324
- EP-A- 0 419 663
- JP-A-62 054 962
- PATENT ABSTRACTS OF JAPAN, vol. 13, no. 192 (E753), 09.05.89 & JP-A-1 013 772

## Beschreibung

Die Erfindung betrifft einen Halbleiterspeicher nach dem Oberbegriff des Patentanspruchs 1.

Ein derartiger Halbleiterspeicher ist bekannt aus der japanischen Offenlegungsschrift 54962/87, und darin können Daten in jeder Zelle unabhängig von anderen Zellen eingeschrieben oder gelöscht werden. Die Speicherzellen dieses Speichers sind in einer Reihe angeordnet, indem die Source- und Drainzonen der Zellentransistoren in Reihe geschaltet sind. Die Anordnung mehrerer Reihen von Speicherzellen zu einer Gruppe ist grundsätzlich bekannt aus z.b. der WO-A-90 04 855. Parallel zu der Reihe von Speicherzellen ist eine Programmier-Leitung innerhalb des Gateoxids integriert. Diese Programmier-Leitung besteht aus polykristallinem Silicium und liegt unter dem Floating-Gate und ist von diesem durch ein dünnes Tunneloxid getrennt. Bei der Herstellung derartiger Speicherzellen muß das Tunneloxid auf der Programmier-Leitung aufgebracht werden.

Aufgabe der Erfindung ist es, einen Speicher anzugeben, dessen Zellen unabhängig von anderen Speicherzellen eingeschrieben und gelöscht werden können.

Diese Aufgabe wird gemäß der Erfindung durch die im Patentanspruch 1 angegebenen Merkmale gelöst.

Wenn gemäß einer Weiterbildung der Erfindung sich das Floating-Gate nicht über die gesamte Weite des Kanals erstreckt, so daß in jeder Speicherzelle ein dem Floating-Gate-Transistor parallel geschalteter, nur durch das Controllgate gesteuerter Parallel-Transistor gebildet ist, kann auf einen zusätzlichen Zugriffstransistor verzichtet werden, ohne daß sich bei kurzen Zugriffszeiten Probleme durch Überlöschen (over erasing) von Speicherzellen ergeben.

Weitere Ausgestaltungen der Erfindung ergeben sich aus den Unteransprüchen.

Die Erfindung betrifft weiter ein Verfahren zum Betrieb eines Halbleiterspeichers nach dem Hauptanspruch 1, gemäß dem die angelegten Spannungen so gewählt sind, daß beim Lesen einer Speicherzelle die Parallel-Transistoren der nicht selektierten Speicherzellen leitend sind. So ist sichergestellt, daß unabhängig von dem durch etwaiges Überlöschen bedingten Zustand der Speicherzellen nur die selektierte Zelle gelesen wird. Die Zahl der Speicherzellen eines Zellenblocks ist dabei nur durch die höchstzulässige Zugriffszeit begrenzt.

Ein Ausführungsbeispiel der Erfindung wird im folgenden anhand der beigefügten Zeichnungen näher erläutert.
Es zeigen:
- Fig. 1: das Layout einer Speicherzelle eines Halbleiterspeichers nach der Erfindung,
- Fig. 2: das Layout einer aus 4 Speicherzellen nach Fig. 1 bestehenden Speicherzellengruppe,
- Fig. 3: einen Schnitt durch eine Speicherzelle entlang der Linie III-III in Figur 1,
- Fig. 4: einen Schnitt durch eine Speicherzelle entlang der Linie IV-IV in Figur 1 und
- Fig. 5: das Schaltbild der aus 4 Speicherzellen bestehenden Speicherzellengruppe nach Fig. 2.

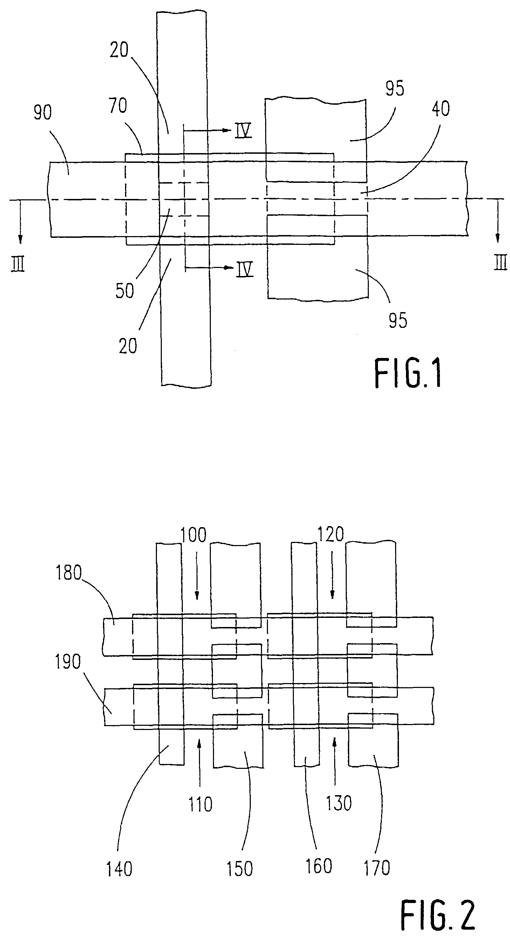

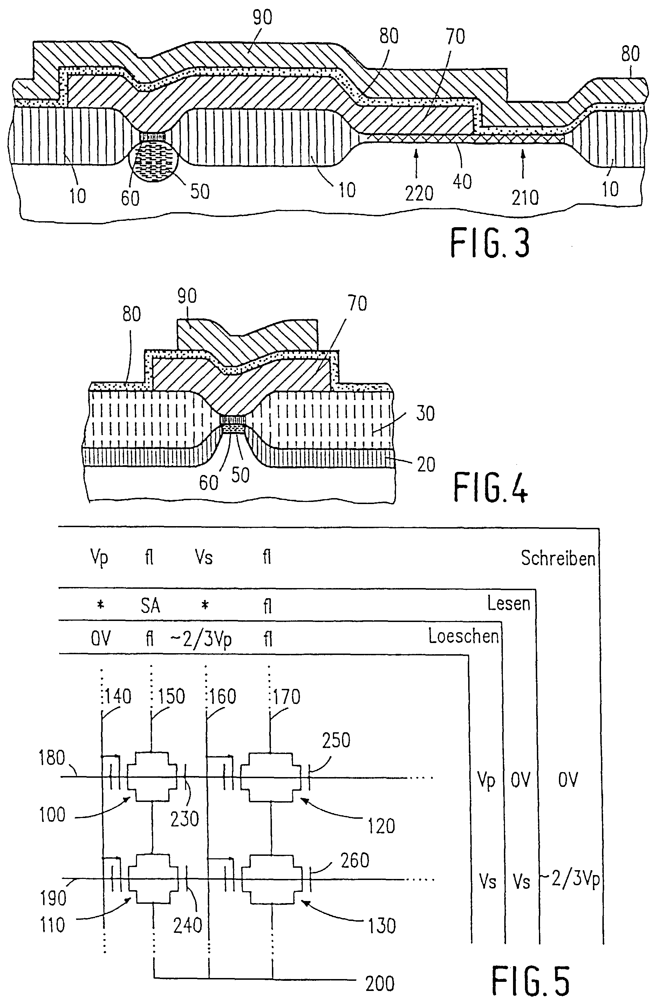

Die Figur 1 zeigt das Layout einer Speicherzelle eines erfindungsgemäßen Halbleiterspeichers. Ein Schnitt durch diese Speicherzelle entlang der Linien III-III und IV-IV ist in den Figuren 3 und 4 dargestellt.
Realisiert sind die Speicherzellen in einem Substrat aus P-leitendem Silicium.
Auf diesen Halbleiterkörper wird zunächst ein etwa 500 nm dickes Oxid 10 aufgewachsen.

Anschließend werden die N⁺-leitenden Gebiete 20, die später zusammen mit den Injektorgebieten die Programmier-Leitung bilden durch Implantation erzeugt. Dann wird wieder oxidiert, so daß sowohl das zuerst aufgebrachte Oxid 10 als auch das über den Gebieten 20 gebildete Oxid 30 eine Dicke von etwa 800 nm haben.
Im nächsten Schritt wird das Gateoxid 40 mit einer Dicke von 25 nm aufgewachsen. Bei 60 wird dieses Oxid dann abgeätzt, das Injektorgebiet 50 implantiert und dann ein etwa 8 nm dickes Tunneloxid 60 aufgewachsen.

Anschließend wird die das Floating-Gate bildende erste Polysiliciumschicht 70 deponiert, dotiert und strukturiert.
Anschließend wird ein etwa 40 nm dickes Dielektrikum 80 aus Oxinitrid und darauf dann eine zweite, das Controll-Gate bildende, etwa 200 bis 400 nm dicke Polysiliciumschicht 90 aufgebracht und diese dann dotiert und strukturiert.

Der Transistor der so hergestellten Speicherzelle besteht also - wie Fig. 3 zeigt - aus zwei parallel geschalteten Transistoren, wobei der eine Transistor 220 durch den unter dem Floating-Gate 70 liegenden Teil des Kanals und der zweite zusätzliche Transistor 210 durch den nur unter dem Controllgate 90 liegenden Teil des Kanals gebildet wird.

Die Source- und Draingebiete 95 dieser Transistoren werden durch Implantation nach dem Aufbringen der zweiten Polysiliciumschicht 90 selbstjustierend hergestellt. Es ist aber auch möglich sie durch eine vergrabene n+-leitende Schicht zu bilden.

In der Figur 2 ist eine, nur als Beispiel dienende Speicherzellengruppe mit 2x2 Speicherzeilen dargestellt und in der Figur 5 das Schaltbild dieser Gruppe mit den Zellen 100, 110, 120, 130.
Die Bit-Leitung für die Zellen 100 und 110 ist mit 150 bezeichnet, die Bit-Leitung für die Zellen 120 und 130 mit 170. Die an einer Bit-Leitung liegenden Zellen sind in Serie geschaltet, so daß die Source der Zelle 100 gleichzeitig die Drain der Zelle 110 bildet usw. Die Sourcegebiete der letzten Zellen jeder Spalte liegen an einer gemeinsamen Sourceleitung 200. Die Wort-Leitung für die Zellen 100 und 120 ist mit 180 und die Wort-Leitung für die Zellen 110 und 130 mit 190 bezeichnet. An einer Wort-Leitung liegen abhängig von der Speichergröße 8 ∗ x Zellen. Die Programmier-Leitungen 140 und 160 dienen zum Programmieren/Löschen der Zellen 100 und 110 bzw. 120 und 130.

Der Halbleiterspeicher wird nun so betrieben, daß die angelegten Spannungen so gewählt sind, daß beim Lesen die Parallel-Transistoren (240, 260) der nichtselektierten Speicherzellenzeilen einer Speicherzellengruppe leitend sind.
Soll z.B. die Zelle 100 selektiert und gelesen werden, so wird an die Wort-Leitungen (hier 190) der nichtselektierten Zellen die Versorgungsspannung Vs (z.B. 5 V angelegt), so daß unabhängig vom Ladungszustand des Floating-Gate-Transistors der Parallel-Transistor 240, 260 durchgeschaltet ist. An die Wort-Leitung 180 an der die auszulesende Zelle liegt, wird eine Spannung von 0 V angelegt, so daß der Parallel-Transistor 230 sperrt. An die Bit-Leitung 150 ist ein Leseverstärker SA angeschlossen und die gemeinsame Sourceleitung 200 auf Massepotential gelegt. Es hängt jetzt von dem Ladungszustand des Floating-Gates der Speicherzelle 100 ab ob ein Strom fließt (wenn das Gate positiv ist, entspricht einer logischen 1) oder kein Strom fließt (wenn das Gate negativ ist, entspricht einer logischen 0).

Zum Löschen der selektierten Zelle 100 wird an die Wort-Leitung 180 an der diese Zelle liegt, die Programmierspannung Vp (etwa 13 V) angelegt und an die Programmleitung 140 an der diese Zelle liegt, 0 V. Durch die kapazitive Kopplung zwischen der ersten Polysiliciumschicht 70, d.h. dem Floating-Gate und der zweiten Polysiliciumschicht 90, d.h. dem Controllgate, fällt ein Großteil der angelegten Spannung Vp über dem Tunneloxid 60 (siehe Figur 3 und 4) ab, so daß durch ein Fowler-Nordheim-Tunnelstrom Elektronen auf das Floating-Gate 70 gelangen und es negativ aufladen. Damit die nichtselektierten Zellen 110, 120 und 130 nicht mit gelöscht werden, liegen an der Wort-Leitung 190, an der nur nichtselektierte Zellen liegen, die Betriebsspannung Vs und an der nichtselektierten Programm-leitung 160 etwa 2/3 Vp.
Um in die selektierte Zelle 100 zu schreiben, wird an die Wort-Leitung 180 an der diese Zelle liegt, 0 V angelegt, an die Programmleitung 140 an der diese Zelle liegt Vp (etwa 13 V). Durch die kapazitive Kopplung zwischen der ersten Polysiliciumschicht 70, dem Floating-Gate, und der zweiten Polysiliciumschicht 90, dem Controll-Gate,fällt wieder ein Großteil der angelegten Spannung Vp über dem Tunneloxid 60 ab, so daß wieder durch einen Fowler-Nordheim-Tunnelstrom Elektronen vom Floating-Gate 70 herunterfließen und es positiv aufladen. Damit die nichtselektierten Zellen 110, 120 und 130 nicht mitprogrammiert werden, liegen an der Wort-Leitung 190 an der nur nichtselektierte Zellen liegen, etwa 2/3 Vp an und an der Programm-Leitung für die nichtselektierten Zellen die Spannung Vs. Die bei den drei Vorgängen: Löschen, Lesen, Schreiben an den Wort- Bit- und Programmierleitungen liegenden Spannungen sind (für den Fall, daß die Zelle 100 selektiert ist) in die Randleisten der Fig. 5 eingetragen. Dabei bedeutet fl daß diese Leitung schwebt (floatet), während * bedeutet, daß die Leitung schwebt oder an ∼ 1/2 Vs liegt.

## Patentansprüche

1. Halbleiterspeicher mit einer Anzahl in einem Halbleiterkörper angordneter, elektrisch mit Fowler-Northeim-Tunnelstrom programmier- und löschbarer, nichtflüchtigen Speicherzellen (EEPROM), von denen jede eine Source- und Drainzone (95) und einen dazwischen gebildeten Kanal mit einem darüber liegenden Gateoxid (40), ein sich über das Gateoxid (40) erstreckendes Floating-Gate (70) und ein sich über das Floating-Gate (70) erstreckendes und von ihm durch ein dünnes Dielektrikum (80) getrenntes Controllgate (90) aufweist, wobei Speicherzellenspalten dadurch gebildet sind, daß die Source und Drain von n Zellen in Serie geschaltet sind und diese serielle Verbindung eine Bit-Leitung (150, 170) für die Spalte bildet, und parallel zur Bit-Leitung eine Programmier-Leitung (20, 140, 160) angeordnet ist, die von den Floating-Gates (70) durch ein dünnes Tunneloxid (60) getrennt ist,
dadurch gekennzeichnet, daß zur Bildung einer Speicherzellengruppe mit m Spalten und n Zeilen das Controllgate (90) von m nebeneinander liegenden Speicherzellen einer Zeile einer Gruppe gemeinsam ist und eine Wort-Leitung (180, 190) für eine Zeile der Gruppe bildet und daß unter einem Teilbereich jedes Floating-Gates (70) liegende Gebiete (50) des Halbleiterkörpers als Injektorgebiete in entgegengesetzter Leitfähigkeit wie der übrige Halbleiterkörper dotiert sind und die Gebiete (50) der n Zellen einer Spalte einer Gruppe miteinander verbunden sind und so die Programmier-Leitung (20; 140, 160) bilden, die von den Source- und Drainzonen getrennt ist.

2. Halbleiterspeicher nach Anspruch 1,
dadurch gekennzeichnet,
daß sich das Floating-Gate (70) nicht über die gesamte Weite des Kanals erstreckt, so daß in jeder Speicherzelle ein dem Floating-Gate-Transistor (220) parallel geschalteter, nur durch das Controllgate (90) gesteuerter Parallel-Transistor (210) gebildet ist.

3. Halbleiterspeicher nach Anspruch 2,
dadurch gekennzeichnet,
daß die Injektorgebiete (50) der einzelnen Zellen eine Spalte durch hochdotierte Gebiete (20) gleichen Leitungstyps so miteinander verbunden sind, daß eine streifenförmige Programmier-Leitung (140, 160) gebildet ist.

4. Verfahren zum Betrieb eines Halbleiterspeichers nach einem der Ansprüche 2 oder 3,
dadurch gekennzeichnet,
daß die angelegten Spannungen so gewählt sind, daß beim Lesen die Parallel-Transistoren (210) der nicht selektierten Speicherzellen leitend sind.

## Claims

1. A semiconductor memory with a number of non-volatile memory cells which are arranged in a semiconductor body and which are electrically programmable and erasable by means of a Fowler-Northeim tunneling current (EEPROM), each of which cells comprises a source and drain zone (95) and a channel formed between them with a superimposed gate oxide (40), a floating gate (70) which extends over the gate oxide (40), and a control gate (90) which extends over the floating gate (70) and is separated therefrom by a thin dielectric (80), columns of memory cells being formed by a series arrangement of the sources and drains of n cells, which series arrangement forms a bit line (150, 170) for the column, while a programming line (20; 140, 160) is connected in parallel to the bit line and separated from the floating gate (70) by a thin tunnel oxide (60),
characterized in that, for forming a memory cell group of m columns and n lines, the control gate (90) of m memory cells lying next to one another is common to a line of a group and forms a word line (180, 190) for a line of the group, and in that regions (50) of the semiconductor body lying under a partial region of each floating gate (70) are doped with a conductivity type opposed to that of the remaining semiconductor body so as to form injector regions, and in that the regions (50) of the n cells of a column of a group are interconnected so as to form the programming line (20; 140, 160) which is separated from the source and drain zones.

2. A semiconductor memory as claimed in Claim 1,
characterized in that the floating gate (70) does not extend over the entire width of the channel, so that a parallel transistor (210) is formed in each memory cell, which parallel transistor is connected in parallel to the floating-gate transistor (220) and is controlled only by the control gate (90).

3. A semiconductor memory as claimed in Claim 2,
characterized in that the injector regions (50) of the individual cells of one column are interconnected by means of highly doped regions (20) of the same conductivity type such that a strip-shaped programming line (140, 160) is formed.

4. A method of operating a semiconductor memory as claimed in any one of the Claims 2 or 3,
characterized in that the applied voltages are so chosen that the parallel transistors (210) of the non-selected memory cells are conducting during reading.

## Revendications

1. Mémoire à semi-conducteurs avec plusieurs cellules de mémoire non volatiles programmables et effaçables électriquement avec un courant de tunnel de Fowler-Nordheim et disposées dans un corps à semi-conducteurs (EEPROM) dont chacune présente une zone source et une zone drain (95) et un canal formé entre elles avec un oxyde de grille (40) disposé au-dessus, une grille flottante (70) s'étendant sur l'oxyde de grille (40) et une grille de contrôle (90) s'étendant sur la grille flottante (70) et étant séparée de celle-ci par un fin diélectrique (80), les rangées des cellules de mémoire étant formées par le fait que la source et le drain de n cellules sont montés en série et que ce montage en série forme une ligne binaire (150, 170) pour la rangée et, parallèlement à la ligne binaire, une ligne de programmation (20, 140, 160) qui est séparée des grilles flottantes (70) par un fin oxyde de tunnel (60) est disposée parallèlement à la ligne binaire,
caractérisée en ce que, pour la formation d'un groupe de cellules de mémoire de m colonnes et n rangées, la grille de contrôle (90) de m cellules de mémoire adjacentes est commune à une ligne d'un groupe et forme une ligne de mots (180, 190) pour une ligne du groupe et que des zones (50) du corps à semi-conducteurs situées sous une zone partielle de chaque grille flottante (70) sont dotées à titre de zones d'injecteurs de conductibilité opposée à l'autre corps à semi-conducteurs et que les zones (50) des n cellules d'une colonne d'un groupe sont reliées entre elles et forment ainsi la ligne de programmation (20; 140, 160) qui est séparée par les zones source et drain.

2. Mémoire à semi-conducteurs selon la revendication 1,
caractérisée en ce que la grille flottante (70) ne s'étend pas sur toute la largeur du canal de telle sorte qu'un transistor parallèle (210) commandé seulement par la grille de contrôle (90) est monté en parallèle au transistor de la grille flottante (220) et formé dans chaque cellule de mémoire.

3. Mémoire à semi-conducteurs selon la revendication 2,
caractérisée en ce que les zones d'injecteur (50) des différentes cellules d'une colonne sont reliées entre elles par des zones fortement dotées (20) du même type de conductivité de telle sorte qu'une ligne de programmation (140, 160) en forme de strie est formée.

4. Procédé de gestion d'une mémoire à semi-conducteurs selon l'une des revendications 2 ou 3,
caractérisé en ce que les tensions appliquées sont choisies de telle sorte que lors de la lecture, les transistors parallèles (210) des cellules de mémoire non sélectionnées sont conducteurs.
